# EUROPEAN PATENT APPLICATION

(11) **EP 2 581 844 A1**
(43) Date of publication of application: **17.04.2013**
(21) Application number: 12185172.9
(22) Date of filing: 20.09.2012
(51) Int. Cl.: G06F 17/50

(54) **Global clock handler object for HDL environment**

(30) Priority: 14.10.2011 US 201113274015
(71) Applicant: APPLE INC., Cupertino, CA 95014 (US)
(72) Inventor: Yang, William W., Cupertino, CA 95014 (US); Fernando, Chameera R., Cupertino, CA 95014 (US)
(74) Representative: Lang, Johannes

(57) **Abstract**

A global clock handler module for use in a hardware description language (HDL) environment is disclosed. An HDL module may include one or more clock statements. When a computer system executes the clock statements, a clock handler object may be called. The clock handler object may generate simulated clock signals for one or more simulated functional blocks of an integrated circuit design. Each simulated clock may be assigned to a separate and unique thread. The clock handler object may be a singleton object configured to manage each simulated clock signal for an integrated circuit design. Generation and control of each simulated clock signal may be performed by the clock handler object in a dynamic array. The dynamic array may include elements specifying parameters for each of the simulated clock signals.

## Description

### Field of the Invention

This invention relates to hardware description languages (HDLs), and more particularly, to the generation and control of simulated clock signals in HDL environments.

### Description of the Related Art

Due in part to the high level of integration achievable with modern fabrication techniques, integrated circuit designs have become very complex. Complex integrated circuits having a high level of integration are impractical to design at a circuit level or even at a logic gate level. Accordingly, to manage complex integrated circuit designs, various hardware description languages (HDLs) have been developed. An HDL allows for a high-level description of an integrated circuit. The description may be in the form of software code executable on a computer system to simulate the integrated circuit design. Additionally, HDL's may be used to write modules known as a testbench, which may be used to test other modules that describe specific pieces of hardware.

A typical integrated circuit design may include a number of different functional units. For example, a system-on-a-chip (SOC) design may include multiple processor cores, at least one memory, a graphics processing unit, a switching unit, and one or more interface circuits. Each of these different functional units may be described by a separate HDL module. More particularly, each HDL module may be described by a number of statements of HDL code that are effectively a shorthand description of the functional unit. These statements may specify the inputs and outputs of the functional block along with additional statements describing its internal operation. Many of these functional units may require a clock signal. Accordingly, each corresponding HDL module may include a number of statements specifying a clock signal, with parameters such as frequency, start time, stop time, and various statistical monitoring states.

### SUMMARY

A global clock handler object for use in a hardware description language (HDL) environment is disclosed. In one embodiment, an HDL module may include one or more clock statements. When a computer system executes the clock statements, a clock handler object may be called. The clock handler object may generate simulated clock signals for one or more simulated functional blocks of an integrated circuit design. Each simulated clock may be assigned to a separate and unique thread. The clock handler object may be a singleton object configured to manage each simulated clock signal for an integrated circuit design.

In one embodiment, an HDL module known as a testbench may include a number of different clock statements. The testbench may be configured to perform testing of another HDL module that embodies an integrated circuit design (the device under test, or 'DUT'). Responsive to execution of the clock statements, the testbench may invoke the clock handler object to generate simulations of corresponding clock signals and to assign them to respective ports of the DUT. Each clock handler statement may specify certain parameters of a corresponding simulated clock signal. Such parameters may include (but are not limited to) frequency, start time, stop time, and offset relative to another clock signal. The clock handler object may maintain a dynamic array to keep track of the various simulated clock signals and their corresponding parameters. The clock handler object may generate and control all of the simulated clock signals for the operation of the testbench and during the simulation of the DUT in accordance with the testbench. The clock handler object may be a singleton object, i.e. may be instantiated once during the simulation of an integrated circuit design.

### BRIEF DESCRIPTION OF THE DRAWINGS

The following detailed description makes reference to the accompanying drawings, which are now briefly described.

Fig. 1 is a block diagram of one embodiment of an integrated circuit design and a corresponding group of hardware description language (HDL) modules corresponding to the design.

Fig. 2 is a block diagram illustrating the organization of a one embodiment of a group of HDL modules including a clock handler object and a testbench module for testing an integrated circuit design.

Fig. 3 is a diagram illustrating a dynamic array maintained by one embodiment of a clock handler object.

Fig. 4 is a flow diagram illustrating one embodiment of a method for initiating testing of an integrated circuit design using a testbench.

Fig. 5 is a block diagram of one embodiment of a computer readable medium.

While the invention is susceptible to various modifications and alternative forms, specific embodiments thereof are shown by way of example in the drawings and will herein be described in detail. It should be understood, however, that the drawings and detailed description thereto are not intended to limit the invention to the particular form disclosed, but on the contrary, the intention is to cover all modifications, equivalents and alternatives falling within the spirit and scope of the present invention as defined by the appended claims. The headings used herein are for organizational purposes only and are not meant to be used to limit the scope of the description. As used throughout this application, the word "may" is used in a permissive sense (i.e., meaning having the potential to), rather than the mandatory sense (i.e., meaning must). Similarly, the words "include", "including", and "includes" mean including, but not limited to.

Various units, circuits, or other components may be described as "configured to" perform a task or tasks. In such contexts, "configured to" is a broad recitation of structure generally meaning "having circuitry that" performs the task or tasks during operation. As such, the unit/circuit/component can be configured to perform the task even when the unit/circuit/component is not currently on. In general, the circuitry that forms the structure corresponding to "configured to" may include hardware circuits and/or memory storing program instructions executable to implement the operation. The memory can include volatile memory such as static or dynamic random access memory and/or nonvolatile memory such as optical or magnetic disk storage, flash memory, programmable read-only memories, etc. Similarly, various units/circuits/components may be described as performing a task or tasks, for convenience in the description. Such descriptions should be interpreted as including the phrase "configured to." Reciting a unit/circuit/component that is configured to perform one or more tasks is expressly intended not to invoke 35 U.S.C. § 112, paragraph six interpretation for that unit/circuit/component.

### DETAILED DESCRIPTION OF EMBODIMENTS

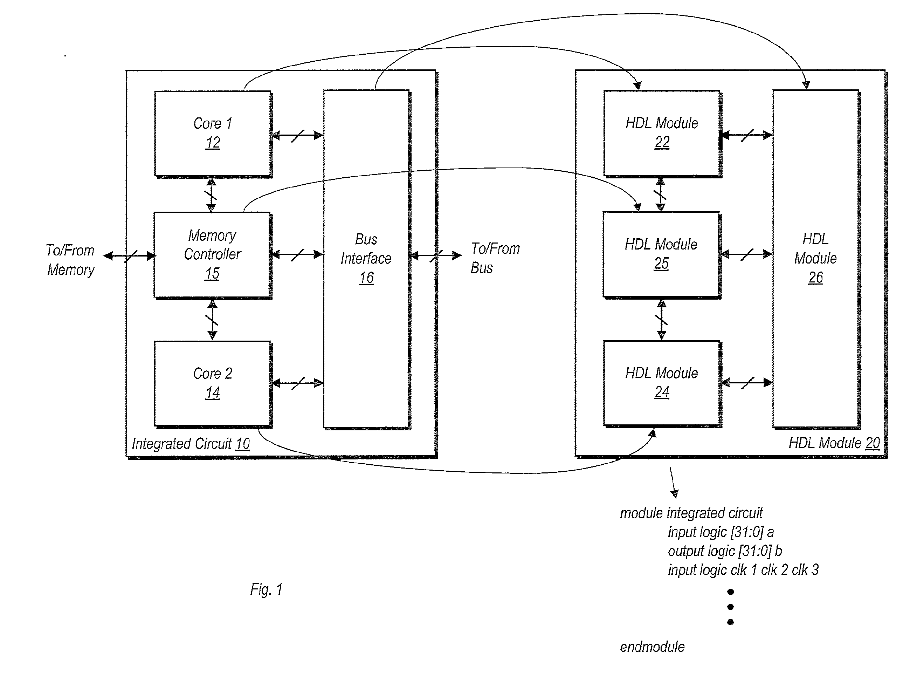

Turning now to Fig. 1, a block diagram of one embodiment of an integrated circuit design and a corresponding group of hardware description language (HDL) modules corresponding to the design is illustrated. Integrated circuit (IC) 10 in the embodiment shown is a block diagram of a preliminary IC design that includes multiple functional blocks. It is noted that the IC 10 illustrated here is exemplary, and it not intended to be limiting.

In its proposed design, IC 10 is a multi-core processor having two cores, core 12 and core 14. In one embodiment, cores 12 and 14 may be identical to one another. In another embodiment, the cores may be different, e.g., one core may be implemented for general processing while another core is dedicated to graphics processing. IC 10 further includes a memory controller 15 coupled to both cores. In the final implementation, memory controller 15 is to be configured for providing an interface to a system memory. IC 10 also includes a bus interface 16 coupled to both cores and to memory controller 16. Bus interface 16 in the final implementation is to be configured to provide an interface between IC 10 and one or more peripheral buses. More particularly, bus interface 16 may coordinate traffic flow between devices attached to a peripheral bus and the other functional blocks of IC 10.

In the example illustrated in Fig. 1, the design of IC 10 may be represented by hardware description language (HDL) module 20, which in turn is composed of additional HDL modules. HDL module 22 in this example is an HDL description of core 12. Similarly, HDL modules 24, 25, and 26 provide HDL descriptions of core 14, memory controller 15, and bus interface 16, respectively. In HDL (i.e. prior to compilation), each module may include a number of statements. The HDL statements may specify inputs to each module, outputs from each module, the operations performed by each module, and so on. It is further noted that each of the HDL modules shown in Fig. 1 may themselves include additional HDL modules therein. For example, a given HDL module shown in Fig. 1 may include additional modules such as adders, dividers, multiplexers, memories, various types of state machines, and so on. Some HDL modules within HDL module 20 may be obtained from pre-designed libraries, while others may be written during the design process of IC 10.

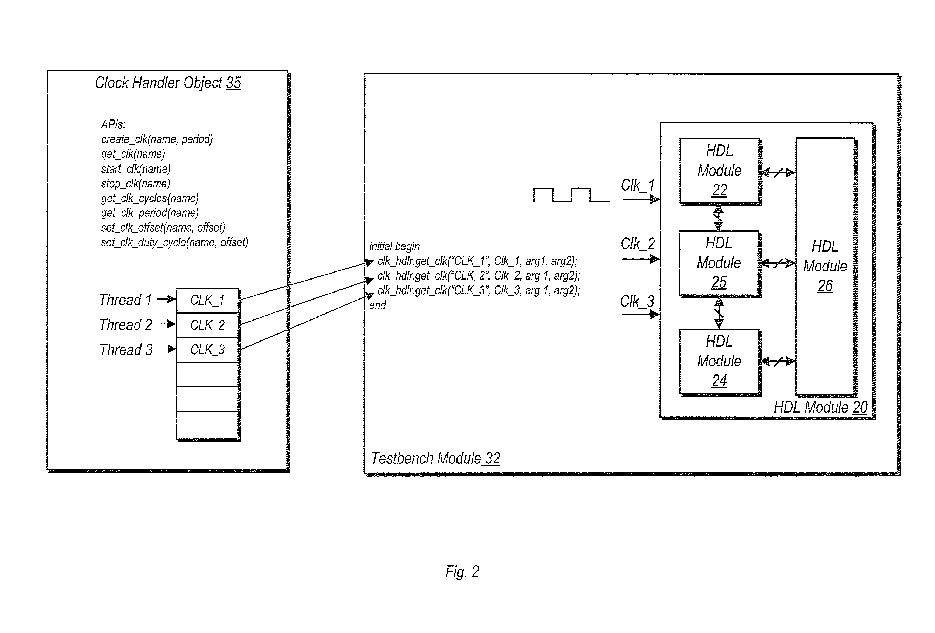

Fig. 2 is a block diagram illustrating the organization of a one embodiment of a group of HDL modules including a clock handler object and a testbench module for testing an integrated circuit design. Testbench 32 in the given example is an HDL module that is configured to perform testing of the IC design described in HDL module 20 and the various modules thereof described above with respect to Fig. 1. Accordingly, testbench 32 in the embodiment shown encompasses HDL module 20 and its various sub-modules. In addition, testbench module 32 may also include a number of HDL statements that, when executed, provide test stimulus to the HDL module 20 and its sub-modules. These statements may in some cases check the results produced by providing the test stimulus, although separate verification statements may also be included in testbench 32 for tests that are more complex and/or require more time to complete.

Testbench 32 in the embodiment shown includes a number of exemplary clock statements. When executed, these clock statements call clock handler object 35. Responsive to execution of each of the clock statements, clock handler object 35 may generate a corresponding simulated clock signal to be provided into one of the clock ports (e.g., Clk_1, Clk_2) of HDL module 20. Clock handler object 35 may also generate simulated clock signals to be provided internally to portions of HDL module 20 instead of through clock ports. In either case, clock handler object 35 may provide simulated clock signals to each of the HDL modules corresponding to a functional block that utilizes one or more clock signals during operation. In general, clock handler object 35 may generate simulated clock signals for any portion of HDL module 20 and its respective sub-modules.

Clock handler object 35 in the embodiment shown is a singleton object. That is, only on instance of clock handler object 35 is active during the execution of testbench 32 and/or the simulation of the IC design via HDL module 20. Furthermore, clock handler object 35 in the embodiment shown is configured to generate and control all simulated clock signals for a given simulation, and thus acts as a global clock handler. In contrast, prior art embodiments did not include centralized clock control as provided by clock handler object 35, instead generating simulated clock signals and all of their respective parameters in separate sections of HDL code.

Each clock statement illustrated in the example of Fig. 2 specifies the clock handler object ('clk_hdlr'), a function to be performed by the clock handler (e.g., 'get_clk'), a clock name (e.g., 'CLK_1'), a clock port to which the simulated clock is to be assigned (e.g., 'Clk_1') and one or more arguments. The arguments may be used to specify clock signal parameters such as the clock signal frequency. Furthermore, the application programming interfaces (API's) of clock handler object 35 may be used to set additional parameters for a simulated clock signal. Accordingly, an HDL module that calls clock handler object 35 may also include clock statements creating a simulated clock signal, specifying a start time, a stop time, a number of cycles to run, and a duty cycle, and an offset (relative to another clock signal) among other possible parameters. Clock statements calling these functions may be placed anywhere within an HDL module, including testbench module 32.

It is noted that the format of the clock statements and the API's in the illustrated embodiment of clock hander object 32 are exemplary. Other formats are possible and contemplated.

Clock handler object 32 in the embodiment shown is configured to generate and control simulated clock signals on a thread-by-thread basis. That is, clock handler object 35 in the embodiment shown is configured to generate a separate thread of execution for each of the simulated clock signals. In the example shown, Thread 1 is dedicated to CLK_1, Thread 2 is dedicated to CLK_2, and Thread 3 is dedicated to CLK_3. Providing separate threads for each simulated clock signal may simplify the management and control of multiple simulated clock signals that are concurrently active. For example, a change of a parameter for a given simulated clock signal may affect the thread dedicated to the same without affecting the corresponding threads of the other simulated clock signals.

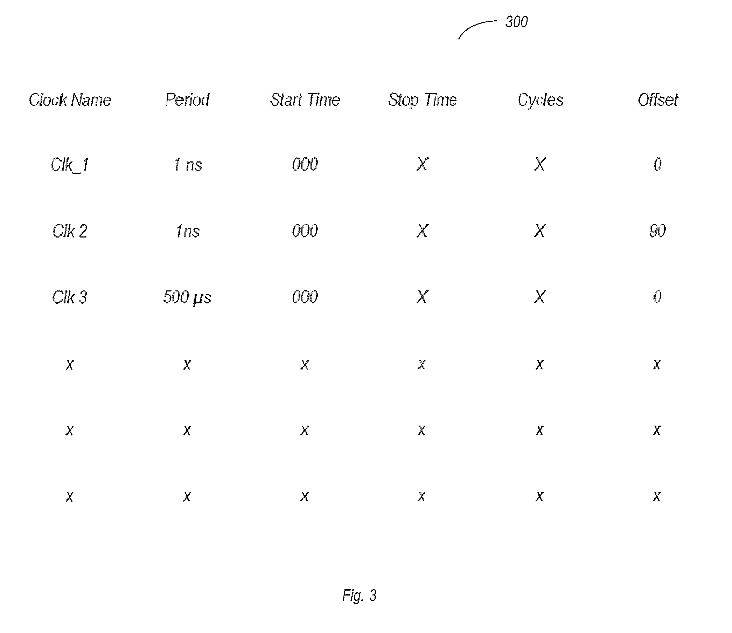

Clock handler object 35 may generate and maintain a dynamic array in order to manage multiple simulated clock signals. The array may be dynamic in that its size may be increased or decreased as needed. Fig. 3 is a diagram illustrating a dynamic array maintained by one embodiment of a clock handler object. In the embodiment shown, array 300 includes a number of elements, arranged in rows and columns. Each of the elements of array 300 corresponds to one of the simulated clock signals generated by clock handler object 35. The various parameters stored as elements in array 300 may include those mentioned above, such as clock name, period/frequency, start time, stop time, and so on. Additional parameters not explicitly discussed or shown in Fig. 3 may also be present in some embodiments.

As previously noted, array 300 is a dynamic array. Thus, for example, when a clock statement calls clock handler object 35 to request a simulated clock signal, a new set of elements may be added to array 300. The new set of elements may correspond to the newly requested simulated clock signal. Furthermore, clock handler object 35 may remove elements from array 300 if they are no longer needed. For example, if a simulated clock signal is to operate for only an early portion of a simulation/test, clock handler object 35 may remove its respective elements from array 300 when the simulated clock signal becomes inactive. Clock handler object 35 may also change the values of certain elements of array 300 during a simulation/test. For example, if a clock statement specifying a change of offset value for a given simulated clock signal, clock handler object 35 may update a corresponding element in array 300 while putting the requested change into effect.

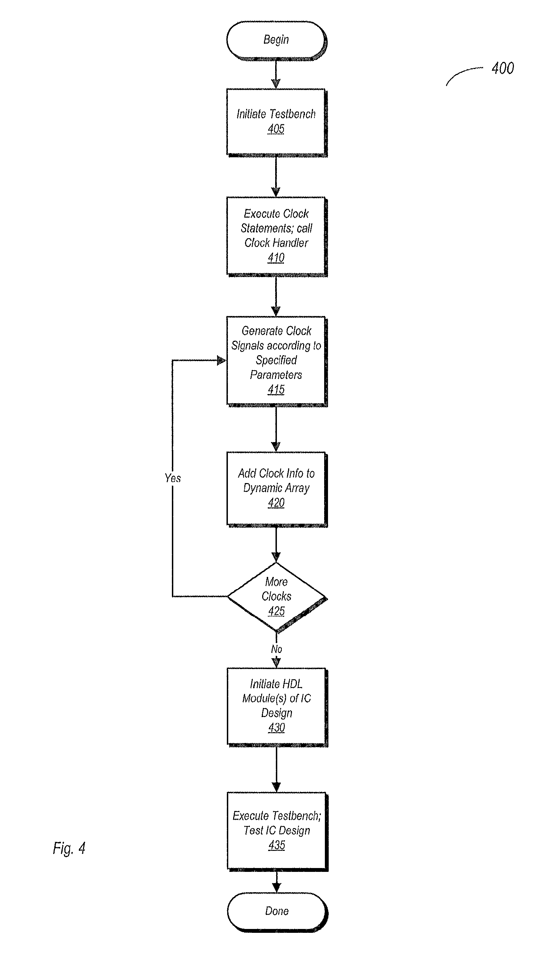

Fig. 4 is a flow diagram illustrating one embodiment of a method for initiating the testing of an IC design using a testbench. In the embodiment shown, method 400 begins with the execution of one or more instructions that initiate a testbench module (block 405). In one embodiment, the one or more instructions initiating a testbench module, as well as other instructions executed in method 400, may be machine language instructions compiled from HDL statements. Embodiments in which an interpreter is used to execute HDL statements are also possible and contemplated.

After initiating of the testbench module, instructions corresponding to one or more clock statements may be executed, with a clock handler object called in response thereto (block 410). The clock hander object may then generate corresponding simulated clock signals according to any specified parameters (block 415). The clock handler object may add, to a dynamic array, elements corresponding to various parameters of any newly generated clock signal simulation (block 420). Execution of a first clock statement may generate the dynamic array. Execution of additional clock statements that request a new simulated clock signal (block 425, yes) may add corresponding elements to the dynamic array. Additional clock statements that specify certain parameters for a simulated clock signal that was previously generated may cause the dynamic array to be updated.

If no additional simulated clock signals are to be generated prior to beginning simulation of the IC design and testing thereof (block 425, no), then HDL modules corresponding to the IC design may be initiated (block 430). It is noted however that embodiments wherein the HDL modules describing the IC design and the functional blocks thereof are initiated prior to the execution and generation of simulated clock signals are also possible and contemplated.

Once all of the testbench, the desired clock signal simulations, and the HDL modules corresponding to the IC design have all been initiated, the execution of the testbench and the testing of the IC design may commence (block 435). During execution of the testbench, test vectors may be provided to various inputs of the IC design, and the results of the testing may be captured through various outputs. The capture of the test results may be analyzed to determine whether the IC design functions correctly and within specifications.

Although method 400 includes the generation of one or more simulated clock signals via the execution of clock statements prior to beginning testing, it is noted that additional clock statements may be executed at any time during the method. For example, a clock statement changing the offset of one simulated clock signal relative to another may be executed subsequent to beginning testing. Furthermore, statements starting and/or stopping a simulated clock signal may also be executed during testing. In some cases, if a simulated clock signal is inactivated for the remainder of a test sequence, the clock handler object may eliminate corresponding elements from the dynamic array to reduce its size and thus its memory footprint. In general, clock statements may be executed at any time during the operation of a testbench and/or simulation of an IC design. Furthermore, while the present disclosure has use the example of clock statements being executed from within a testbench, it is noted that clock statements calling the clock handler object may be executed from within any HDL module, including those describing a functional unit of an IC design.

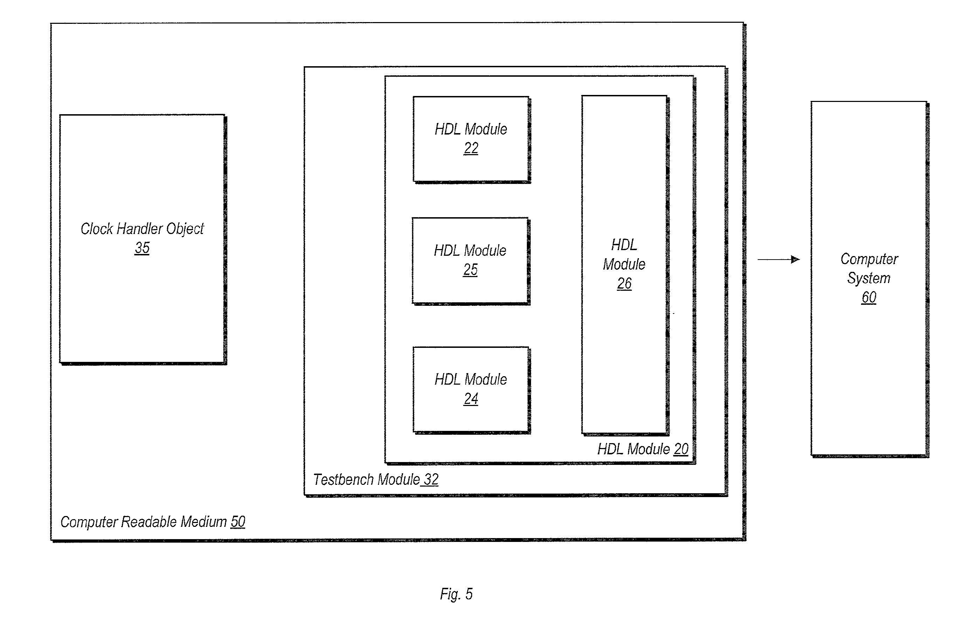

Fig. 5 is a block diagram of one embodiment of a computer readable medium. In the embodiment shown, computer readable medium 50 is a non-transitory computer readable medium. Examples of a non-transitory computer readable medium include flash memory (e.g., in a flash drive), hard disk storage, CD-ROM, DVD-ROM, and so on. In general, computer readable medium 50 may be any type of non-transitory computer readable medium from which an appropriately equipped computer system may access the information stored thereon.

In this particular example, computer readable medium 50 stores the various data structures that make up clock handler object 35, testbench module 32, HDL module 20, and each of its various sub-modules (HDL modules 22, 24, 25, and 26). As used herein, the term 'data structures' may include any instruction, data, or other information of any of clock handler object 35, testbench 32, and the various HDL modules stored on computer readable medium 50.

A computer system 60 is also shown in Fig. 5. Computer system 60 is not shown here in detail, but may be virtually any type of computer system that can access information from computer readable medium 50. Furthermore, computer system 60 may also be configured to perform simulation and testing of an IC design described using various HDL modules. Computer system 60 may include one or more processors or processor cores, various types of memory (e.g., dynamic random access memory, or DRAM) and storage (e.g., hard disk drives) and various ports through which the data from computer readable medium may be accessed. Computer system 60 may also include software in its respective storage. Such software may include a compiler to convert HDL statements in HDL modules to a machine-readable format (e.g., instructions of a processor instruction set).

Computer readable medium is accessible by computer system 60. More particularly, computer system 60 may access the data structures stored on computer readable medium 50 to perform a simulation of the IC design described by HDL module 20 and its respective sub-modules. The data structures of computer readable medium 50 may also be accessed by computer system 60 to perform testing of the IC design per the test routine(s) described by testbench module 50. The testing may be accomplished by computer system 60 executing instructions from the testbench module 32 as well as from each of HDL modules 20, 22, 24, 25, and 26. In simulations and tests that utilize simulated clock signals, clock handler object 35 may be called by the execution of instructions corresponding to clock statements. Responsive to the execution of instructions corresponding to the clock statements, clock handler 35 may generate and control one or more simulated clock signals.

As used herein, HDL may refer to any language that may be used to describe the hardware implemented in an IC. In addition to the industry-known HDL, an HDL per this disclosure may also include languages such as System Verilog, C/C++, and so on.

Numerous variations and modifications will become apparent to those skilled in the art once the above disclosure is fully appreciated. It is intended that the following claims be interpreted to embrace all such variations and modifications.

## Claims

1. A non-transitory computer-readable storage medium having program instructions stored thereon that, if executed, cause a computer to:
receive a request from a first hardware description language (HDL) module to generate a simulated clock signal for simulating operation of an integrated circuit; and
respond to the request by providing a simulated clock signal to the first HDL module.

2. The computer readable medium as recited in claim 1, wherein the clock handler object is a singleton object.

3. The computer readable medium as recited in claim 1, wherein the clock handler object is configured to generate each of a plurality of simulated clock signals inside corresponding unique threads responsive to execution of a corresponding plurality of clock handler statements in the first HDL module.

4. The computer readable medium as recited in claim 1, wherein the clock handler object is configured to set, for the simulated clock signal, an offset relative to another clock signal.

5. The computer readable medium as recited in claim 1, wherein the clock handler object is configured to maintain a dynamic array, wherein each element of the dynamic array includes information regarding one of one or more simulated clock signals.

6. The computer readable medium as recited in claim 1, wherein the clock handler object is configured to generate a plurality of simulated clock signals each corresponding to one of plurality of functional blocks of a design of the integrated circuit described by a corresponding one of a plurality of HDL modules.

7. The computer readable medium as recited in claim 6, wherein the first HDL module is a testbench module configured to test at least one other one of the plurality of HDL modules, and wherein the testbench module includes a plurality of clock statements that, when executed by the computer, generate the plurality of simulated clock signals.

8. The computer readable medium as recited in claim 7, wherein each of the plurality of clock statements is configured to indicate one or more parameters of a corresponding one of the plurality of simulated clock signals, wherein the one or more parameters include a clock period.

9. A method comprising:
a computer system executing a clock handler statement during simulation of an integrated circuit;
a clock handler object executing on the computer system generating a simulated clock signal responsive to execution of the clock handler statement.

10. The method as recited in claim 9, further comprising assigning the simulated clock signal to a simulated clock port of a hardware description language (HDL) module, wherein the HDL module corresponds to a block of the integrated circuit.

11. The method as recited in claim 9, further comprising the clock handler object generating a thread corresponding to the simulated clock signal.

12. The method as recited in claim 9, further comprising the clock handler object setting parameters of the simulated clock signal, wherein the parameters include a clock signal offset.

13. The method as recited in claim 12, further comprising the clock handler object maintaining a dynamic array of information corresponding to the simulated clock signal and one or more additional simulated clock signals, wherein each element of the dynamic array includes information pertaining to a parameter of one of the simulated clock signal or the one or more additional simulated clock signals.

14. The method as recited in claim 13, wherein each element of the dynamic array includes a value indicating a period of a corresponding simulated clock signal.

15. The method as recited in claim 10, further comprising a testbench module conducting a test of the HDL module, wherein the testbench module includes the clock handler statement.
